# FASCICULE DE BREVET EUROPEEN

(11) **EP 0 376 830 B1**
(45) Date de publication et mention de la délivrance du brevet: **10.08.1994**
(21) Numéro de dépôt: 89403632.6
(22) Date de dépôt: 22.12.1989
(51) Int. Cl.: H01L 45/00, H01L 27/12, H01L 21/82

(54) **Procédé de réalisation d'un écran plat à matrice active et d'une RAM, utilisant des composants MIM**
Verfahren zur Herstellung eines flachen Bildschirms mit aktiver Matrix und einer RAM die MIM Bauelemente verwendet
Process for producing an active flat panel matrix and a RAM using MIM components

(30) Priorité: 27.12.1988 FR 8817246
(43) Date de publication de la demande: 04.07.1990
(73) Titulaire: CHAMBRE DE COMMERCE ET D'INDUSTRIE DE PARIS CCIP, 75008 Paris (FR)
(72) Inventeur: Sangouard, Patrick, F-94350 Villiers sur Marne (FR)
(74) Mandataire: Signore, Robert

(56) Documents cités:
- GB-A- 2 091 468
- IEEE ELECTRON DEVICE LETTERS, vol. EDL-7, no. 2, février 1986, pages 134-136, IEEE, New York, US; A. MIMURA et al.: "SOI TFT'S with directly contacted ITO"

## Description

La présente invention a pour objet un procédé de réalisation d'un écran plat à matrice active et d'une RAM, utilisant des composants MIM.

L'invention trouve des applications notamment en affichage, dans la réalisation d'écrans plats à cristaux liquides du genre à matrice active et en informatique, dans la réalisation de mémoires de type RAM (mémoire à accès direct) dynamiques.

Pour exposer les problèmes que l'invention résout, on se placera dans le cas des écrans d'affichage à cristaux liquides et à matrice active. Mais il va de soi que cet exemple n'est pas limitatif et que le cas des mémoires de type RAM n'est pas exclu de l'invention.

On connaît un grand nombre de types d'écrans d'affichage à cristaux liquides. Celui qui se rapproche le plus de l'écran dont la présente invention envisage la fabrication est le type dit à matrice active. Un procédé de réalisation avantageux est le procédé à deux niveaux de masquage divulgué par le document FR-A-2 533 072. Ce procédé permet d'associer à chaque pixel un transistor à couches minces (TFT pour "Thin Film Transistor") dont la grille est reliée à une ligne d'adressage, la source à une colonne et le drain à l'électrode du pixel.

Un écran d'affichage à matrice active est également décrit dans l'article intitulé "SOI TFT's with Directly Contacted ITO", publié par AKIO MIMURA et al. dans IEEE Electron Device Letters, vol. EDL-7, n° 2, Février 86, pages 134-136.

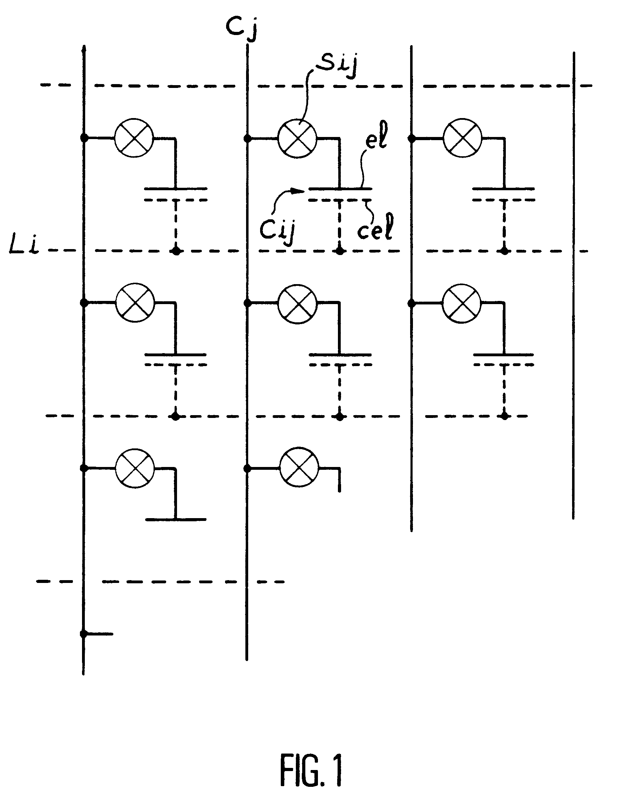

On connaît d'autres écrans dans lesquels l'élément de commutation n'est pas un TFT mais un élément non linéaire. Le schéma général d'un tel dispositif est représenté figure 1. On y voit des colonnes d'adressage Cj et des condensateurs Cij ayant une première armature ou électrode el, cette électrode étant reliée à la colonne voisine à travers un élément non linéaire Sij, le tout étant disposé sur une première plaque non représentée. Les secondes armatures ou contre-électrodes cel sont reliées à des lignes d'adressage Li portées par une seconde plaque non représentée.

L'application de tensions judicieuses sur les lignes Li et les colonnes Cj permet de charger ou de décharger le condensateur Cij à travers l'élément Sij. Le champ électrique résultant permet de commander l'état optique du cristal liquide présent entre les deux plaques et d'afficher ainsi un point d'une image ("pixel").

Le document GB-A-2 091 468 divulgue un tel écran et un procédé de réalisation dans le cas où l'élément non linéaire Sij est un composant dit MIM, c'est-à-dire un empilement métal-isolant-métal.

Dans le document GB-A-2 091 468, les composants MIM sont obtenus par dépôt d'un premier film métallique, anodisation produisant un film d'oxyde, puis dépôt d'un second film métallique sur l'oxyde.

Une telle technique présente de nombreux inconvénients :
- tout d'abord, elle exige quatre niveaux de masquage et photolithogravure, ce qui pénalise lourdement le rendement de fabrication, lequel décroît exponentiellement avec le nombre de niveaux,
- ensuite, le recours au phénomène d'oxydation anodique exige des manipulations de la plaque support et pose de sérieux problèmes lorsqu'il s'agit d'obtenir des épaisseurs d'isolants homogènes de l'ordre de 10 à 100 nm, comme c'est le cas lorsqu'on utilise l'effet thermoionique Schottky ou Poole-Frenkel préconisé dans le document; en effet, l'homogénéité de l'épaisseur, celle des qualités di électriques et physiques et celle de la porosité de la couche d'oxyde anodique, dépendent de l'uniformité de la densité de courant lors de l'oxydation anodique ; cette densité est elle-même une fonction du relief des couches sous-jacentes (effets de pointe), de l'électrolyte utilisé, de ses impuretés, de sa température, du pH, de l'agitation et du vieillissement du bain; en particulier, toute impureté électrochimique de l'électrolyte, notamment les anions contenus dans le bain, sont susceptibles d'être piégés dans l'oxyde, ce qui entraîne des risques de claquage électrique et des instabilités de conduction,
- enfin, le mécanisme de conduction lié aux effets Schottky ou Poole-Frenkel, dans les couches d'oxyde épaisses (10 à 100 nm) dépend exponentiellement de la température, ce qui oblige à une régulation thermique précise, délicate et coûteuse du dispositif final.

Le but de l'invention est de remédier à tous ces inconvénients. A cette fin, elle propose un procédé de réalisation de composants MIM particulièrement simple et qui, lorsqu'il est utilisé pour réaliser un écran d'affichage, ne nécessite que deux niveaux de masquage. Le procédé s'affranchit de toutes les difficultés liées à l'anodisation et conduit à un phénomène de conduction quasiment insensible à la température et à la luminosité.

Selon l'invention, on procède par oxydo-réduction mutuelle de deux matériaux mis en contact l'un avec l'autre.

De façon plus précise, la présente invention a pour objet un procédé de réalisation d'un écran d'affichage comprenant un substrat isolant transparent supportant des colonnes d'adressage, une matrice d'électrodes et une matrice d'éléments de commutation, chaque élément de commutation étant constitué par au moins un composant MIM disposé entre une colonne d'adressage et une électrode, ce procédé étant caractérisé par le fait que pour réaliser les composants MIM :
- on forme sur le substrat, aux endroits des futurs composants MIM, un empilement comprenant un premier matériau qui est un conducteur oxydant et un second matériau qui est un conducteur oxydable,
- on porte cet empilement à une température comprise entre 200°C et 700°C, ce qui crée une couche d'oxyde entre les deux matériaux,
- on ramène la température à l'ambiante.

Un tel procédé évite les inconvénients de l'art antérieur et présente de nombreux avantages :
- l'épaisseur de la couche isolante d'interface est commandée de manière reproductible par un simple contrôle de température et de durée du processus d'oxydo-réduction entre les deux matériaux ;
- la couche d'oxyde d'interface obtenue peut facilement être ajustée à une épaisseur de l'ordre de 5 à 10 nm, de sorte que l'effet mis en oeuvre n'est plus du type Schottky ou Poole-Frenkel mais du type effet tunnel ; dans ces conditions, le courant est pratiquement insensible à la température ; par ailleurs, il est insensible à la lumière ; les écrans plats obtenus selon l'invention peuvent donc être utilisés dans un environnement sévère, et par exemple pour la projection d'images de grandes dimensions ;
- la hauteur de la "barrière tunnel" peut être réglée par le choix des matériaux ; la mise en série de plusieurs MIM permet d'ajuster la largeur équivalente de la barrière ; le réglage de la hauteur et de la largeur totale de la barrière tunnel permet de contrôler les caractéristiques courant-tension des MIM et d'optimiser les tensions et courants de commande ;
- la mise en série de composants MIM est très simple et permet de symétriser complètement la caractéristique courant-tension du dispositif ;
- l'homogénéité de l'épaisseur des couches de matériaux oxydant et oxydable, soit au sein d'un même MIM, soit d'un MIM à l'autre, n'est pas critique, puisque le phénomène conduisant à la formation de la couche d'oxyde se produit à l'interface des deux couches et non en volume ;
- le procédé de l'invention peut être mis en oeuvre quelle que soit la dimension de l'écran car l'obtention des MIM est automatique ; il peut en particulier être utilisé pour des écrans de très grandes dimensions, ce que ne permet pas le procédé à TFT ou le procédé électrolytique décrits plus haut ; les moyens techniques à mettre en oeuvre sont simples et en particulier n'exigent pas de salle blanche ; en d'autres termes, la technologie utilisée est peu coûteuse et peut être qualifiée de "rustique" ;
- il n'y a aucun risque de pollution de l'isolant puisque celui-ci est forme in situ, sans jamais être exposé à l'atmosphère ; l'élément oxydant est interne au système des deux matériaux ;
- il y a continuité physico-chimique dans tout le composant MIM et non pas superposition de couches comme dans l'art antérieur, ce qui évite nombre des inconvénients liés à la superposition de différents matériaux et en particulier les problèmes d'adhérence entre couches.

Il faut observer que la formation d'une mince couche d'oxyde entre un conducteur oxydant et un conducteur oxydable par élévation de température n'est pas un phénomène physique nouveau en soi. Il est mentionné par exemple dans l'article de AKIO MIMURA et al. cité plus haut. Toutefois, il est essentiel de souligner que ce phénomène n'a jamais été mis en oeuvre pour former un écran d'affichage à matrice active à composants MIM. Dans l'article cité, si le phénomène en question est évoqué, c'est pour souligner son caractère défectueux et il est bien recommandé de l'éviter. De manière précise, dans le document cité, la structure visée n'est pas à MIM mais à TFT. Un contact ohmique doit être formé sur la source en silicium dopé n du TFT et ce contact est obtenu par dépôt de ITO. C'est lors de la formation de ce contact que les auteurs ont constaté qu'avec une température de recuit dépassant 200°C (et s'établissant par exemple à 400 ou 600°C) il se formait une couche intercalaire d'oxyde entre l'ITO et le silicium. Cette couche détruisant le caractère ohmique du contact recherché, il convient de l'éviter en maintenant la température à une valeur inférieure à 200°C. C'est pour cette raison d'ailleurs que le silicium est impérativement déposé en premier sur le substrat isolant car ce dépôt s'effectue à une température beaucoup plus élevée que 200°C (par exemple à 900°C). La couche d'ITO n'est déposée qu'ensuite, en dessous de 200°C. Si l'on inversait l'ordre des opérations, en déposant d'abord l'ITO, pour constituer préalablement un futur contact de source et en effectuant ensuite le dépôt de silicium à 900°C, on créerait une couche isolante entre ITO et le silicium, ce que les auteurs veulent justement éviter.

Ainsi, l'homme du métier cherche-t-il toujours, dans cette technique, à éviter la formation d'une couche isolante et cela en opérant à température réduite. L'invention va donc à l'encontre de ce préjugé, en préconisant au contraire la formation de cette couche d'oxyde par élévation de température. L'écran n'est plus alors à TFT mais plus avantageusement à MIM. Il en résulte par ailleurs que rien n'interdit plus d'inverser l'ordre des dépôts, c'est-à-dire d'effectuer d'abord le dépôt d'oxyde conducteur puis celui du semiconducteur, ce qui, dans certains cas, peut être intéressant.

L'invention présente encore un autre avantage lié au temps de commande de l'écran. Le demandeur a observé que, dans le cas où le conducteur oxydable était un semiconducteur, comme le silicium par exemple, la formation d'une couche d'oxyde s'accompagnait de l'apparition d'une zone de charge d'espace à l'interface semiconducteur-isolant. Cette charge d'espace a pour effet de créer un second condensateur en série avec le condensateur correspondant à la couche isolante, ce qui entraîne une diminution considérable de la capacité de l'ensemble, par rapport à la valeur qu'on obtiendrait par exemple si le conducteur oxydable était en métal. Or, on sait que dans un écran à matrice active, la capacité du composant MIM doit normalement être inférieure à la capacité du pixel, si l'on veut que les charges définissant le champ électrique commandant l' affichage soient avant tout présentes sur le pixel et non dans le composant MIM. Jusqu'à présent, la capacité du composant MIM était de l'ordre du tiers de la capacité d'un pixel. Avec le procédé de l'invention, la présence de la charge d'espace diminue la capacité du composant MIM à une valeur égale à environ le dixième de la capacité du pixel, ce qui est beaucoup plus favorable. C'est donc bien le pixel qui apportera la contribution capacitive la plus grande à l'écran d'affichage.

Pour cette raison, dans une variante préférée, l'invention préconise l'utilisation d'un semiconducteur comme matériau conducteur oxydable. Ce semiconducteur peut être le silicium, le germanium, un composé binaire comme l'arseniure de gallium ou le phosphure d'indium, ou un composé ternaire (GaAlAs) ou même quaternaire.

Quant au matériau conducteur oxydant il peut être pris dans le groupe des oxydes métalliques conducteurs du type oxyde d'indium (In₂O₃), oxyde d'étain (SnO₂), oxyde d'indium et d'étain (ITO), (In₂O₃ + SnO₂), l'oxyde de zinc (ZnO), etc.

Le matériau conducteur oxydable, lorsqu'il n'est pas semiconducteur, peut être pris dans le groupe des mélanges d'oxydes (V₂O₅ - P₂O₅) (V₂O₅ - PbO - Fe₂O₃), des métaux Al, Ti, Ta, Ag, Cr, Cu, Mn, Mo, etc., ou des alliages oxydables.

Dans tous les cas, la température de formation de l'oxyde est supérieure à 200°C et en général inférieure à 700°C. C'est donc une technologie basse ou moyenne température. Par exemple, pour un ensemble substrat verre-ITO-aluminium, la température est avantageusement de 350°C environ. Pour un ensemble substrat-verre-ITO-polysilicium, la température peut être de 625°C environ. Pour le couple ITO-titane la température peut être de 520°C environ.

L'étape thermique peut s'effectuer sous vide ou en présence de gaz (argon, oxygène par exemple). Sa durée dépend de l'épaisseur de la couche isolante souhaitée. En général, cette durée est de l'ordre de 3 heures.

L'étape thermique peut s'effectuer après formation de l'empilement, mais elle peut intervenir aussi pendant formation de cet empilement si l'opération de dépôt des couches s'effectue dans la plage requise pour l'oxydo-réduction.

La présente demande a également pour objet un procédé de réalisation d'une mémoire RAM dynamique comprenant une matrice de condensateurs de stockage avec des lignes d'adressage et des colonnes d'adressage et un élément de commutation disposé entre chaque condensateur et une ligne ou une colonne, caractérisé par le fait que pour réaliser les éléments de commutation :
- on forme un empilement comprenant un premier matériau qui est un conducteur oxydant et un second matériau qui est un conducteur oxydable,
- on porte cet empilement à une température comprise entre 200°C et 700°C, ce qui crée des composants MIM,
- on ramène la température à l'ambiante.

De toute façon, les caractéristiques de l'invention apparaîtront mieux à la lumière de la description qui suit, d'exemples de réalisation donnés à titre explicatif et nullement limitatif. Cette description se réfère à des dessins annexés sur lesquels :
- la figure 1, déjà dérite, montre la structure générale d'un écran d'affichage à matrice active et à élément non linéaire de type MIM,
- la figure 2A montre les premières étapes (a, b, c, d, e) d'un premier mode de réalisation d'un écran d'affichage,
- la figure 2B montre les dernières étapes (a, b, c) de ce mode de réalisation,
- la figure 3A montre les premières étapes (a, b) d'un second mode de réalisation d'un écran d'affichage,
- la figure 3B montre les dernières étapes (a, b) de ce second mode de réalisation,
- la figure 4 illustre l'allure des pistes graves sur la contre-plaque,
- la figure 5A illustre une étape d'un procédé de réalisation d'une mémoire RAM dynamique,
- la figure 5B illustre les autres étapes dudit procédé.

Dans la description qui va suivre, on supposera que le substrat est en verre, que le matériau conducteur oxydant est de l'ITO (oxyde d'étain et d'indium), et que le matériau oxydable est du silicium, dopé ou non. Mais il va de soi que c'est à titre purement explicatif et que d'autres matériaux ou combinaisons de matériaux peuvent être employés, comme indiqué plus haut.

Dans le cas envisagé, la couche isolante des composants MIM est alors de la silice résultant de l'oxydation du silicium par la couche d'ITO.

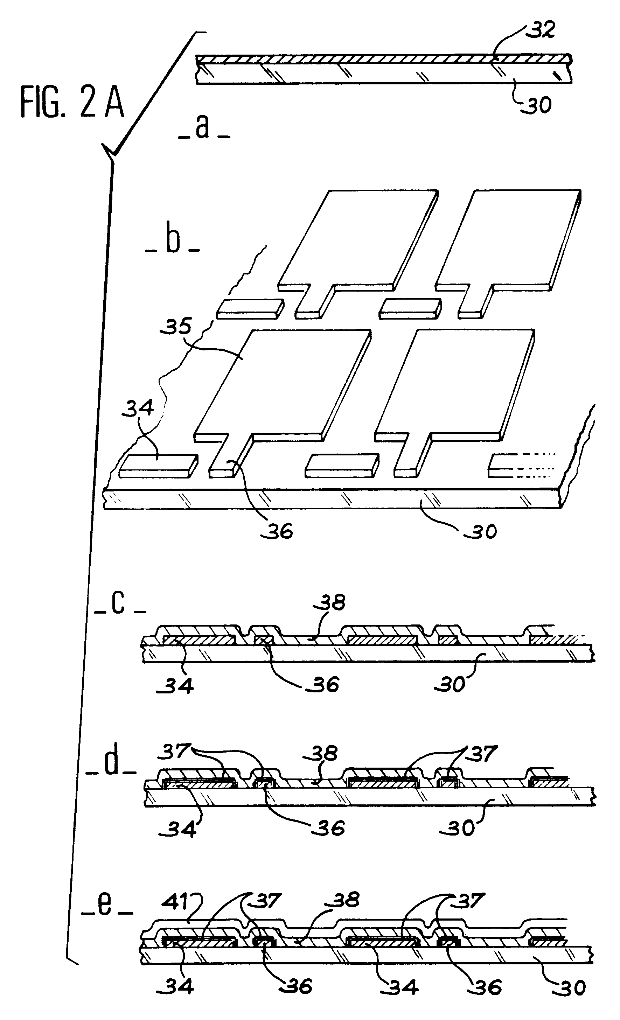

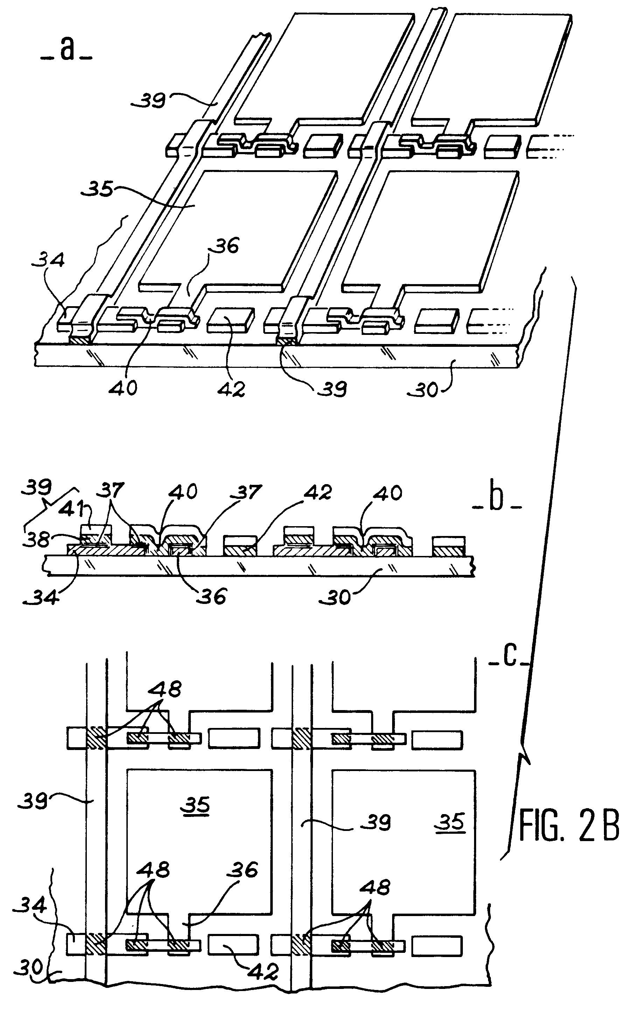

Sur les figures 2A et 2B, on voit différentes étapes de réalisation de la plaque qui supporte la matrice de pixels et les MIM, selon un premier mode de réalisation employant une couche oxydante située en dessous et une couche oxydable en silicium située au-dessus. On observera, à cet égard, que cette disposition est l'inverse de celle du document cité plus haut, pour les raisons déjà invoquées.

Les différentes opérations et étapes sont les suivantes :

### Figure 2A :

- a :: sur un substrat isolant transparent 30, dépôt d'une couche 32 en ITO,
- b :: photolithogravure d'une matrice de premiers motifs de connexion 34, et d'une matrice d'électrodes 35 ayant chacune un appendice 36 ;
- c :: dépôt d'une couche 38 de silicium (dopé ou non) sur l'ensemble autour de 625°C,
- d :: étape thermique à 625°C pour constituer, par oxydo-réduction entre le silicium et l'ITO, une couche de silice 37,
- e :: dépôt éventuel au-dessus du silicium, d'un métal 41 (Al, W, Mo, etc.) dans le cas où la résistance électrique du matériau oxydable est faible, cette étape n'est pas nécessaire.

### Figure 2B :

- a :: photolithogravure de la couche métallique 41, du silicium 38 et de la silice 37 pour former des colonnes d'adressage 39 chevauchant transversalement une partie des premiers motifs 34 et des seconds motifs de connexion 40 et chevauchant longitudinalement une partie des premiers motifs 34 et transversalement les appendices 36. La gravure peut laisser subsister des plots 42 constituant ce qu'il est convenu d'appeler une "black-matrix" destinée à masquer les lignes d'adressage de la contre-électrode,
- b, c :: on obtient alors trois dispositifs MIM en série aux endroits référencés 48. Le métal 41 ne sert qu'à court-circuiter la résistance intrinsèque du silicium.

Dans cette réalisation, la croissance de la silice par oxydo-réduction entre le silicium et l'ITO peut être obtenue aussitôt que la température de dépôt du silicium est suffisante. Ainsi, l'isolant des futurs MIM peut être élaboré au cours de l'étape 2Ac : l'étape 2Ad est alors une étape de vieillissement et d'homogénéisation des structures MIM.

On voit qu'un tel processus ne nécessite que deux niveaux de masquage et est donc très simple à mettre en oeuvre, notamment avec des plaques de grandes dimensions.

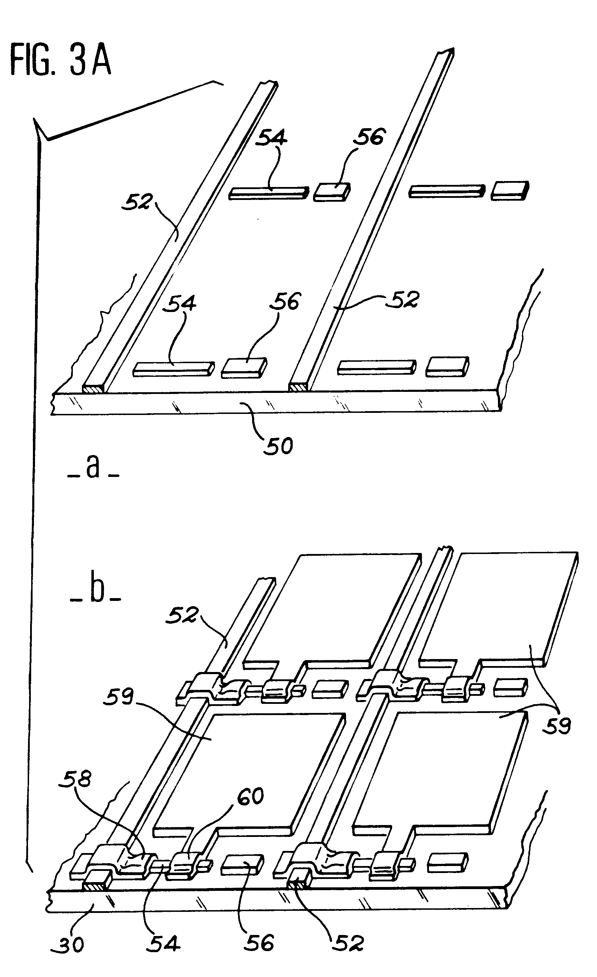

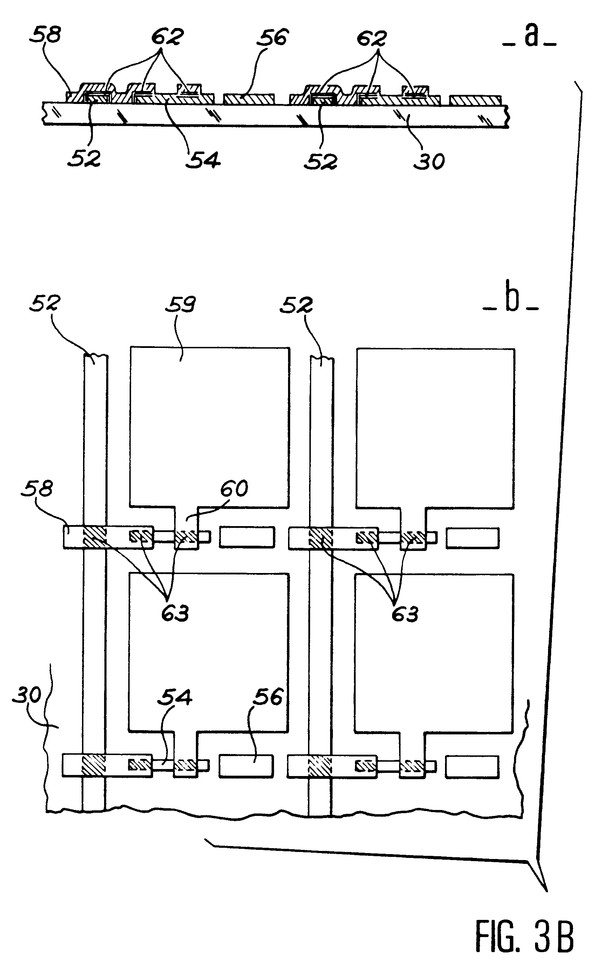

Dans un autre mode de réalisation, on inverse l'ordre des matériaux et on dépose d'abord le conducteur oxydable puis le conducteur oxydant. C'est ce qui est illustré sur les figures 3A et 3B dans le cas où le matériau oxydant est de l'ITO et le matériau oxydable du tantale. Les étapes et opérations sont les suivantes :

### Figure 3A :

- a :: sur un substrat de verre 50, dépôt d'une couche de tantale et photolithogravure de colonnes 52, de premiers motifs de connexion 54 et de plots 56 de la "black matrix" ;
- b :: dépôt d'une couche d'ITO et gravure pour former des seconds motifs de connexion 58 chevauchant les colonnes 52 et une extrémité des premiers motifs 54 et pour former une matrice d'électrodes 59 avec des appendices 60 chevauchant les motifs 54 ;

### Figure 3B :

- a, b :: étape thermique autour de 475°C pour former de l'oxyde de tantale (Ta₂O₅) 62 aux endroits référencés 63. On obtient alors une structure de trois dispositifs MIM en série entre chaque colonne 52 et chaque électrode 59.

Ce procédé de réalisation ne nécessite que deux niveaux de photolithogravure.

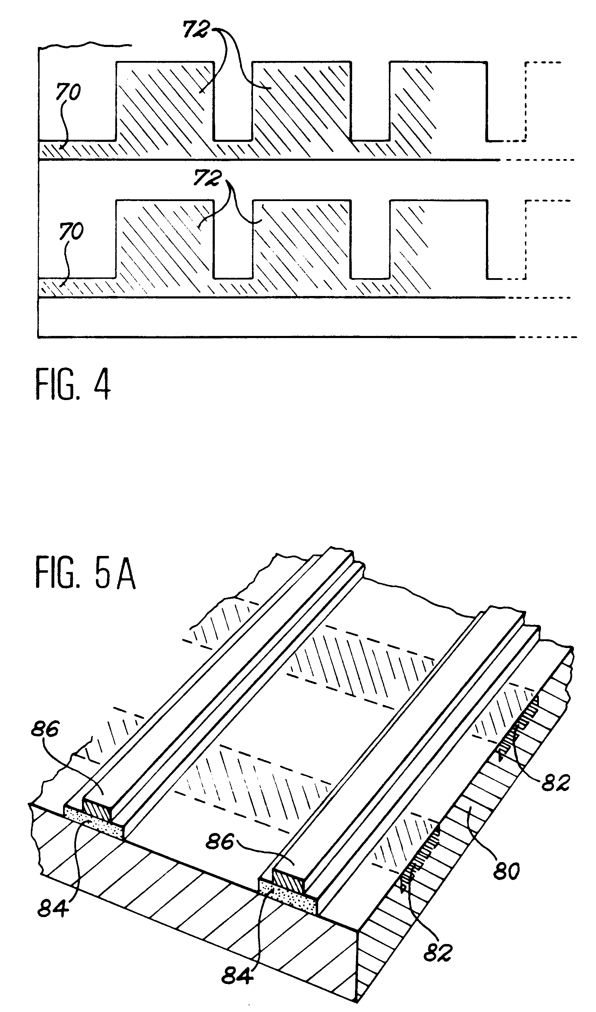

Ces opérations (figures 2A, 2B, 3A, 3B) permettent de constituer la plaque support de la matrice d'électrodes et de la rangée des colonnes d'adressage. Il reste à réaliser la contre-plaque avec les contre-électrodes et les lignes d'adressage. Cette contre-plaque peut être réalisée par tout moyen connu, comme illustré sur la figure 4, par dépôt sur une plaque de verre d'une couche d'ITO puis gravure pour obtenir des lignes 70 et des contre-électrodes 72.

On termine la réalisation de l'écran par étalement d'une couche d'orientation ("surfactant") sur les deux plaques, sérigraphie d'un mur de colle sur la contre-plaque, dispersion d'espaceurs, assemblage plaque/contre-plaque et remplissage par un cristal liquide.

On peut aussi réaliser un écran d'affichage en couleurs en disposant, sur la contre-plaque, des filtres colorés, par exemple par électrodéposition de poudres colorées ionisées à travers des masques.

On remarquera que les lignes et les colonnes sont sur deux plaques différentes, ce qui annule la possibilité de court-circuit entre ces deux réseaux d'adressage.

L'invention ne se limite pas à la réalisation d'écrans d'affichage. Elle s'applique aussi à la réalisation de composants comme des mémoires RAM dynamiques.

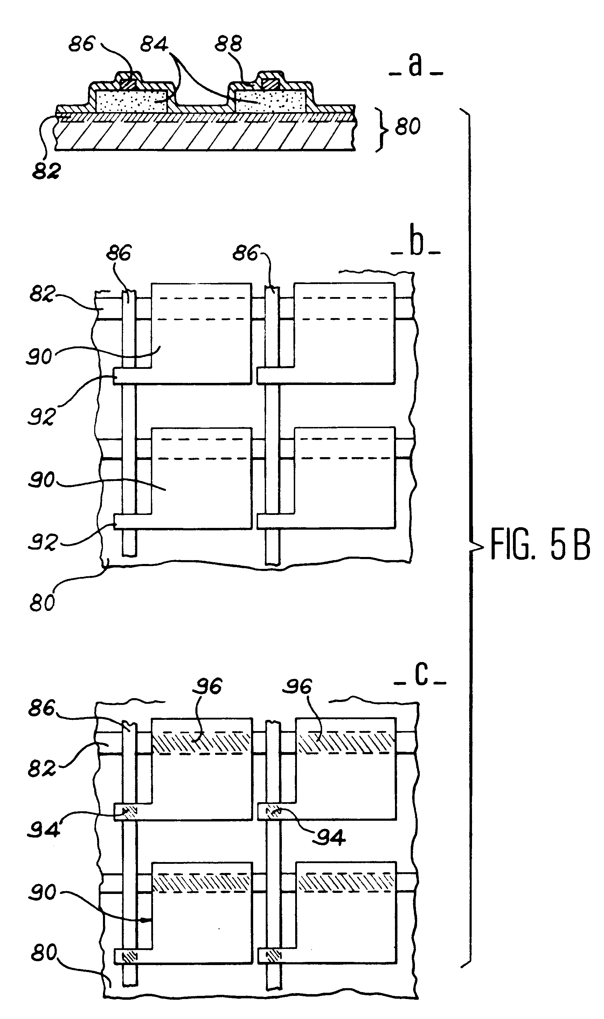

Les figures 5A et 5B illustrent un exemple de réalisation d'une telle mémoire. Un tel dispositif est structurellement comparable au dispositif de la figure 1, si ce n'est que les lignes et les colonnes d'adressage sont contenues dans ou sur le même substrat semi-conducteur. Les opérations peuvent donc être sensiblement les mêmes que celles décrites plus haut, si ce n'est que les diverses couches n'ont plus à être transparentes.

Les diverses étapes et opérations peuvent être les suivantes :

### Figure 5A :

- dans un semi-conducteur 80, par exemple en silicium, dopage d'une série de lignes 82,
- dépôt d'une couche isolante et gravure de colonnes d'isolement 84,
- dépôt d'une couche oxydable et gravure pour laisser subsister des colonnes d' adressage 86,

### Figure 5B :

- a :: dépôt d'une couche 88 de matériau oxydant,
- b :: gravure pour obtenir une matrice de motifs 90 avec des appendices 92 chevauchant les colonnes 86,
- c :: étape thermique pour créer des MIM aux endroits référencés 94, c'est-à-dire au-dessus des colonnes 86 et des capacités 96 aux-dessus des lignes 82.

On remarquera que, d'une part, les interrupteurs MIM 94 et capacités 96 créés automatiquement et que, d'autre part, les capacités 96 formées au-dessus du silicium dopé, ayant une couche d'isolant très mince ou une valeur importante, permettent de réduire la surface et donc d'augmenter la densité d'intégration.

Il est clair qu'on peut mettre en série un nombre quelconque de MIM 94 et ajuster ainsi les valeurs des tensions et courants de commande.

## Revendications

1. Procédé de réalisation d'un écran d'affichage comprenant un substrat isolant transparent (30, 50) supportant des colonnes d'adressage (Cj), une matrice d'électrodes (el) et une matrice d'éléments de commutation (Sij), chaque élément de commutation étant constitué par au moins un composant métal-isolant-métal (MIM) disposé entre une colonne d'adressage (Cj) et une électrode (el), ce procédé étant caractérisé par le fait que pour réaliser les composants MIM :
- on forme sur le substrat, aux endroits des futurs composants MIM, un empilement comprenant un premier matériau qui est un conducteur oxydant et un second matériau qui est un conducteur oxydable,
- on porte cet empilement à une température comprise entre 200°C et 700°C, ce qui crée une couche d'oxyde entre les deux matériaux,
- on ramène la température à l'ambiante.

2. Procédé selon la revendication 1, caractérisé par le fait qu'il comprend les opérations suivantes :
- sur une plaque transparente et isolante (30) on dépose une première couche conductrice (32) en ledit premier matériau oxydant,
- on grave cette première couche pour former une matrice d'électrodes (35) avec un appendice (36) et une matrice de premiers motifs de connexion (34) à l'emplacement des futures colonnes d' adressage,
- on dépose sur l'ensemble une couche (38) en ledit second matériau oxydable,
- on porte l'ensemble à une température comprise entre 200 et 700°C pour constituer une couche d'oxyde (37) entre la couche conductrice et la couche oxydante,
- on grave la seconde couche (38) et la couche d'oxyde (37) pour former des colonnes d'adressage (39) chevauchant les premiers motifs de connexion (34) et former une matrice de seconds motifs de connexion (40) chevauchant les premiers motifs (34) et l'appendice (36) des électrodes (35),
- on ramène la température à l'ambiante.

3. Procédé selon la revendication 1, caractérisé par le fait qu'il comprend les étapes suivantes :
- sur une plaque transparente et isolante (50) on dépose une première couche conductrice oxydable,
- on grave cette première couche pour former des colonnes (52) et une matrice de premiers motifs de connexion (54),
- on dépose sur l'ensemble une seconde couche conductrice oxydante,
- on grave cette seconde couche pour former une matrice de seconds motifs de connexion (58) chevauchant chaque premier motif de connexion (54) et chaque colonne (52), et pour former une matrice d'électrodes (59) avec un appendice (60) chevauchant lesdits premiers motifs de connexion (54),
- on porte l'ensemble à une température comprise entre 200 et 700°C,
- on ramène la température à l'ambiante.

4. Procédé selon l'une quelconque des revendications 1 à 3, caractérisé par le fait que le second matériau oxydable est un semiconducteur.

5. Procédé selon la revendication 4, caractérisé par le fait que le semiconducteur est pris dans le groupe comprenant le silicium, le germanium, les composés binaires, ternaires, quaternaires.

6. Procédé selon l'une quelconque des revendications 1 à 3, caractérisé par le fait que le second matériau oxydable est un métal pris dans le groupe comprenant Al, Ti, Ta, Ag, Cr, Cu, Mn et les alliages oxydables.

7. Procédé selon l'une quelconque des revendications 1 à 6, caractérisé par le fait que le premier matériau conducteur oxydant est pris dans le groupe des oxydes métalliques conducteurs comme l'oxyde d'indium (In₂O₃), l'oxyde d'étain (SnO₂), l'oxyde d'indium et d'étain (ITO soit In₂O₃ + SnO₂) et l'oxyde de zinc (ZnO).

8. Procédé de réalisation d'une mémoire à accès direct (RAM) dynamique comprenant une matrice de condensateurs de stockage (96) avec des lignes d'adressage (82) et des colonnes d'adressage (86) et un élément de commutation (94) disposé entre chaque condensateur et une ligne ou une colonne, caractérisé par le fait que pour réaliser les éléments de commutation (94) :
- on forme un empilement comprenant un premier matériau qui est un conducteur oxydant (88) et un second matériau qui est un conducteur oxydable (86),
- on porte cet empilement à une température comprise entre 200°C et 700°C, ce qui crée des composants métal-isolant-métal (MIM),
- on ramène la température à l'ambiante.

9. Procédé selon la revendication 8, caractérisé par le fait qu'il comprend les opérations suivantes :
- dans un substrat semiconducteur (80) on dope une série de lignes d'adressage (82),
- on dépose une couche isolante et on grave cette couche sous forme de colonnes d'isolement (84),
- on dépose une couche oxydable et on grave cette couche pour laisser subsister des colonnes d'adressage (86),
- on dépose sur l'ensemble une couche (88) de matériau oxydant,
- on grave cette couche (88) pour obtenir une matrice de motifs (90) chevauchant les lignes d'adressage (82) avec un appendice (92) chevauchant les colonnes d'adressage (86),
- on porte l'ensemble à une température comprise entre 200 et 700°C, ce qui crée des composites MIM dans les zones (96) de chevauchement des motifs et des lignes d'adressage (82) et dans les zones (94) de chevauchement des appendices (92) et des colonnes d'adressage (86).

## Claims

1. Method for producing a display screen including a transparent insulating substrate (30,50) supporting addressing columns (Cj), a matrix of electrodes (el) and a matrix of switching elements (Sij), each switching element being constituted by at least one metal-insulator-metal (MIM) component disposed between one addressing column (Cj) and one electrode (el), this method being characterized in that in order to produce the MIM components;
- at the locations of the future MIM components, a stack is formed on the substrate, said stack including a first material, namely an oxidizing conductor, and a second material, namely an oxidizable conductor,
- this stack is heated to a temperature of between 200°C and 700°C, which creates an oxide film between the two materials,
- the temperature is brought back to ambient temperature.

2. Method according to claim 1, characterized in that it includes the following operations:
- onto a transparent insulating plate (30) is deposited a first conductive film (32) of said first oxidizing material,
- this first film is etched so as to form a matrix of electrodes (35) with a piece joined on (36) and a matrix of first connection patterns (34) at the location of the future addressing columns,
- depositing on the unit a film (38) of said second oxidizable material,
- the unit is heated to a temperature of between 200 and 700°C so as to constitute an oxide film (37) between the conductive film and the oxidizing film,
- the second film (38) and the oxide film (37) are etched so as to form addressing columns overlapping the first connection patterns (34) and so as to form a matrix of second connection patterns (40) overlapping the first patterns (34) and the joined on piece (36) of the electrodes (35),
- the temperature is brought back to ambient temperature.

3. Method according to claim 1, characterized in that it includes the following stages:
- a first oxidizable conductive film is deposited on an insulating transparent plate (50),
- this first film is engraved so as to form columns (52) and a matrix of first connection patterns (54),
- a second oxidizing conductive film is deposited on the unit,
- this second film is etched so as to form a matrix of second connection patterns (58) overlapping each first connection pattern (54) and each column (52) and so as to form a matrix of electrodes (59) with a piece joined on (60) overlapping said first connection patterns (54),
- the unit is heated to a temperature of between 200 and 700°C,
- the temperature is reduced to ambient temperature.

4. Method according to any one of the claims 1 to 3, characterized in that the second oxidizable material is a semiconductor.

5. Method according to claim 4, characterized in that the semiconductor is selected from the group including silicon, germanium and binary, ternary and quaternary compounds.

6. Method according to any one of the claims 1 to 3, characterized in that the second oxidizable material is a metal selected from the group comprising Al, Ti, Ta, Ag, Cr, Cu, Mn and oxidizable alloys.

7. Method according to any one of the claims 1 to 6, characterized in that the first oxidizing conductive material is selected from the group of metallic conductive oxides, such as indium oxide (In₂O₃), tin oxide (SnO₂), indium and tin oxide (ITO, i.e. In₂O₃ + SnO₂) and zinc oxide (ZnO).

8. Method for producing a dynamic random access memory (RAM) including a matrix of storage capacitors (96) with addressing rows (82) and addressing columns (96) and a switching element (94) disposed between each capacitor and one row or one column, characterized in that so as to produce the switching elements (94):
- a stack is formed, comprising a first material, namely an oxidizing conductor (88), and a second material, namely an oxidizable conductor (86),
- this stack is heated to a temperature of between 200 and 700°C, which creates metal-insulator-metal (MIM) components,
- the temperature is brought back to ambient temperature.

9. Method according to claim 8, characterized in that it includes the following operations:
- a set of addressing rows (82) is doped into a semiconductive substrate (80),
- an insulating film is deposited and this film is etched in the form of insulating columns (84),
- an oxidizable film is deposited and this film is etched so as to leave addressing columns (86),
- a film of an oxidizing material is deposited on the unit,
- this film (88) is etched so as to obtain a matrix of patterns (90) overlapping the addressing rows with a piece joined on (92) overlapping the addressing columns (86),
- the unit is heated to a temperature of between 200 and 700°C, which creates MIM component zones (96) overlapping the patterns and the addressing rows (82) and in the zones (94) overlapping the pieces joined on (92) and the addressing columns (86).

## Patentansprüche

1. Verfahren zur Herstellung eines Anzeigeschirms umfassend ein transparentes isolierendes Substrat (30, 50), das Adreßspalten (Cj), eine Elektrodenmatrix (el) und eine Matrix mit Schaltelementen (Sij) trägt, wobei jedes Schaltelement aus mindestens einem Metall-Isolator-Metall-Bauelement (MIM) besteht, das zwischen einer Adreßspalte (Cj) und einer Elektrode (el) angeordnet ist, wobei dieses Verfahren dadurch gekennzeichnet ist, daß man zur Herstellung der MIM-Bauelemente :
- auf dem Substrat, an den Stellen der zukünftigen MIM-Bauelemente einen Stapel aus einem ersten Material, das ein oxidierender Leiter ist, und einem zweiten Material, das ein oxidierbarer Leiter ist, bildet
- diesen Stapel auf eine Temperatur zwischen 200° C und 700° C bringt, was zwischen den beiden Materialien eine Oxidschicht erzeugt,
- die Temperatur auf Zimmertemperatur zurückfährt.

2. Verfahren nach Anspruch 1, dadurch gekennzeichnet, daß es folgende Vorgänge umfaßt :
- auf eine transparente und isolierende Platte (30) wird eine erste leitfähige Schicht (32) aus dem ersten oxidierenden Material aufgebracht,
- diese erste Schicht wird graviert, um eine Matrix aus Elektroden (35) mit einem Verlängerungsstück (36) und eine Matrix aus ersten Verbindungsmustern (34) an der Stelle der zukünftigen Adreßspalten zu bilden,
- auf die Anordnung wird eine Schicht (38) aus den zweiten, oxidierbaren Material aufgebracht,
- die Anordnung wird auf eine Temperatur zwischen 200° und 700° C gebracht, um zwischen der leitfähigen Schicht und der oxidierenden Schicht eine Oxidschicht (37) zu bilden,
- die zweite Schicht (38) und die Oxidschicht (37) werden graviert, um Adreßspalten (39) zu bilden, die die ersten Verbindungsmuster (34) übergreifen, und um eine Matrix aus zweiten Verbindungsmustern (40) zu bilden, die die ersten Muster (34) und das Verlängerungsstück (36) dar Elektroden (35) übergreifen,
- die Temperatur wird auf Zimmertemperatur zurückgefahren.

3. Verfahren nach Anspruch 1, dadurch gekennzeichnet, daß es die folgenden Schritte umfaßt :
- auf eine transparente und isolierende Platte (50) wird eine erste leitfähige oxidierbare Schicht aufgebracht,
- diese erste Schicht wird graviert, um Spalten (52) und eine Matrix aus ersten Verbindungsmustern (54) zu bilden,
- auf die Anordnung wird eine zweite leitfähige oxidierende Schicht aufgebracht,
- diese zweite Schicht wird graviert, um eine Matrix aus zweiten Verbindungsmustern (58) zu bilden, die jedes erste Verbindungsmuster (54) und jede Spalte (52) übergreifen, und um eine Matrix aus Elektroden (59) mit einem Verlängerungsstück (60) zu bilden, das die ersten Verbindungsmuster (54) übergreift,
- die Anordnung wird auf eine Temperatur zwischen 200° und 700° C gebracht,
- die Temperatur wird auf Zimmertemperatur zurückgefahren.

4. Verfahren nach einem der Ansprüche 1 bis 3, dadurch gekennzeichnet, daß das zweite oxidierbare Material ein Halbleiter ist.

5. Verfahren nach Anspruch 4, dadurch gekennzeichnet, daß der Halbleiter aus der Gruppe stammt, die Silizium, Germanium, und die binären, ternären und quaternären Zusammensetzungen umfaßt.

6. Verfahren nach einem der Ansprüche 1 bis 3, dadurch gekennzeichnet, daß das zweite oxidierbare Material ein Metall ist, das aus der Gruppe stammt, die Al, Ti, Ta, Ag, Cr, Cu, Mn und die oxidierbaren Legierungen umfaßt.

7. Verfahren nach einem der Ansprüche 1 bis 6, dadurch gekennzeichnet, daß das erste leitfähige oxidierende Material aus der Gruppe der leitfähigen metallischen Oxide stammt, wie Indium-Oxid (In₂O₃), Zinkoxid (SnO₂), Inidum-Zinkoxid (ITO, In₂O₃ + SnO₂) und Zinkoxid (Zno).

8. Verfahren zur Herstellung eines dynamischen Speichers mit direktem Zugriff (RAM), der eine Matrix aus Speicherkondensatoren (96) mit Adreßreihen (82) und Adreßspalten (86) und einem Schaltelement (94), das zwischen jedem Kondensator und einer Reihe oder Spalte angeordnet ist, aufweist, dadurch gekennzeichnet, daß man zur Herstellung der Schaltelemente (94) :
- einen Stapel bildet, der ein erstes Material aufweist, das ein oxidierender Leiter (88) ist, und der ein zweites Material aufweist, das ein oxidierbarer Leiter (86) ist,
- diesen Stapel auf eine Temperatur zwischen 200° C und 700° C bringt, was Metall-Isolator-Metall-Bauelemente (MIM) erzeugt,
- die Temperatur auf Zimmertemperatur zurückfährt.

9. Verfahren nach Anspruch 8, dadurch gekennzeichnet, daß es folgende Vorgänge umfaßt :
- in einem halbleitenden Substrat (80) dotiert man eine Reihe von Adreßzeilen (82),
- man bringt eine isolierende Schicht auf und man graviert diese Schicht in Form von isolierenden Spalten (84),
- man bringt eine oxidierbare Schicht auf, und man graviert diese Schicht, um Adreßspalten (86) stehen zu lassen,
- man bringt auf die Anordnung eine Schicht (88) aus oxidierendem Material auf,
- man graviert diese Schicht (88), um eine Matrix aus Mustern (90) zu erhalten, die die Adreßzeilen (82) übergreifen, und mit einem Verlängerungsstück (92) die Adreßspalten (86) übergreifen,
- man bringt die Anordnung auf eine Temperatur zwischen 200° C und 700° C, was in den übergreifenden Zonen (96) der Muster und der Adreßzeilen (82) und in den übergreifenden Zonen (94) der Verlängerungsstücke (92) und der Adreßspalten (86) MIM-Bauelemente bildet.
